(19) Europäisches Patentamt
European Patent Office
Office européen des brevets

(11) Publication number: **0 154 814**
**A2**

# (12) EUROPEAN PATENT APPLICATION

(21) Application number: **85101425.8**

(22) Date of filing: **11.02.85**

(51) Int. Cl.⁴: **C 23 C 16/50**

(30) Priority: **16.03.84 US 590252**
**16.03.84 US 590251**
**16.03.84 US 590253**
**16.03.84 US 590254**

(43) Date of publication of application: **18.09.85**
**Bulletin 85/38**

(84) Designated Contracting States: **AT BE CH DE FR GB IT LI NL SE**

(71) Applicant: **AMERICAN CYANAMID COMPANY,**
**1937 West Main Street P.O. Box 60, Stamford Connecticut 06904 (US)**

(72) Inventor: **Clasen, Richard H., 146 Pickette Ridge Road, West Redding Connecticut 06896 (US)**
Inventor: **Stevens, Ward Charles, RD 2 Box 13D, New Fairfield Connecticut 06812 (US)**
Inventor: **Beetz, Charles Pershing, Jr., 2600 Grange Hall Road, Ortonville Michigan 48462 (US)**

(74) Representative: **Wächtershäuser, Günter, Dr., Tal 29, D-8000 München 2 (DE)**

(54) **Substrates coated by plasma enhanced chemical vapor deposition, apparatus and process for their production.**

(57) Radio frequency conductive substrates comprising, e.g., plates or fibers of carbon or the like and a thin, uniform firmly adherent film deposited by plasma assisted chemical vapor deposition onto the radio frequency excited substrate, and apparatus for their production. Composites comprising the coated substrates and a continuous matrix of a ceramic or an organic polymer are also disclosed.

EP 0 154 814 A2

29,547

SUBSTRATES COATED WITH FILMS BY PLASMA ENHANCED CHEMICAL VAPOR DEPOSITION, APPARATUS AND PROCESS FOR THEIR PRODUCTION

The present invention relates to subjecting an electrically conductive substrate, for example, carbon fibers, filaments, fibrils, films, ribbons, sheets, plates, and the like to plasma enhanced chemical vapor deposition using capacitively coupled plasma in which the substrate is one of the radiofrequency electrodes. The substrates thus treated, or post-treated, for example, by gas phase grafting, exhibit considerably altered or modified surface characteristics. The invention also relates to composite articles comprised of the substrates which have been subjected to the aforesaid treatment, assembled in heterogeneous combination with a ceramic or an organic polymeric material, the articles exhibiting various improved physical properties such as enhanced mechanical strength.

BACKGROUND OF THE INVENTION

Composite articles comprising ceramics or plastics reinforced with materials of diverse origins, such as glass, carbon, synthetic fibers, silicon carbide, boron, and the like, find wide-spread use in replacing components made of either heavier or lower strength conventional materials such as aluminum, steel, titanium, vinyl polymers, nylons, polyesters, etc., in aircraft, automobiles, office equipment, sporting goods, and in many other fields. The composites comprise two or more components, at least one of which defines a continuous phase, or "matrix", and at least one other defining a "reinforcement" for the assembly.

A common problem in the use of reinforcements in such composites is a seeming lack of ability to translate their properties to the material, e.g., ceramic or heat curable polymer, to which ultimate and intimate contact is to be made. This leads to a loss in properties due to the lack of adhesion between the matrix component and the reinforcing means comprising the composite. The prior art is replete with attempts to improve on the adhesion between matrix and substrate by performing a variety of surface treatments on the reinforcement, and these include various chemical, electrochemical, mechanical, and other treatments.

For example, carbon substrates are often given a post-manufacturing surface treatment which is a light oxidation and this improves interlaminar shear strength in composite materials. In addition, many such substrates are also provided with a sizing in the form of a polymer compatible with epoxy or polyimide matrix resins. Although such techniques are relatively simple and low cost, they have a limited range of utility. Other techniques have also been proposed, such as acid treatment, ammonia treatment, carbide coating, carbon dioxide treatment, electrolytic treatment, irradiation, isocyanate treatment, metal halide treatment, organometallic treatment, whiskerization, and the like. Ion plating treatments, including those which are plasma assisted, are described in numerous patents and publications. For example, S.C. Sanday, Proceedings Fifth Metal Matrix Composites Technology Conference, May, 1983, p. 27-1 to 27-11, deals with ion plating on fibers, in which the plating is ultimately converted to the continuous matrix phase of the composite. Aisenberg, U.S. 3,904,505 and 3,961,103, uses an externally generated plasma to accelerate ion plating, and in this instance, the substrate is radio frequency excited. Inductive plasma assisted vapor deposition is disclosed in three papers by K. R. Linger, Compsites (G.B.) Vol. 8, No. 3, pp. 139-44, July, 1977; Vorabdrucke Plansee Semin, 9th, 1977, 2, D12/1-D12/4 and Proc. Conf. Ion-Plating Allied Tech. 1977, 223-9. Other such treatments are disclosed in Toho Beslon Co. Japanese Patent Publication 58,120,876 (1983) (C.A. 100:8406r), ion bombardment and ion plating; Japanese Patent Publication 79,163,790 (1979) (C.A. 92: 202375 m), ion plating; Japanese Patent Publication 79,162,690 (1979) (C.A. 92:202376n), also ion plating; Japanese Patent Publication 78,34,083 (1978) (C.A. 90: 75547a), plasma etch and ion plating; Japanese Patent Publication 78,66,831 (1976) (C.A. 90:11032w), plasma etch and ion plating; Japanese Patent Publication 78,38,793 (1978) (C.A. 89:91997s), ion plating; Japanese Patent Publication 78,38,791 (1978) (C.A. 89:202717n), ion plating, laminating and hot pressing; and Japanese Patent Publication 77,27,826 (1977) (C.A. 87:43143n), plasma etch and ion plating. Also known are plasma sprayed coating techniques, e.g., C.A. 96:56379e, in which the metal comes out as fine particles which are

deposited as such on the fibers. Other plasma treatments are known, e.g., the plasma generated heat-treated surface modifications on carbon described in Boom, U.S. 3,723,289; 3,824,398; and 3,780,255, and in Hou, U.S. 3,762,941 and 3,767,774, and the superficial cathode sputtering modifications in Masotti, et al., U.S. 3,813,282. A polyphenylene polymer is deposited from a plasma as a coating on carbon as described in Hou, U.S. 3,745,104 and 3,853,600. Fujimori, et al., Japanese Patent Publication No. 70,770, 1983, vaguely describes the use of a plasma assisted chemical vapor deposition of silicon carbide onto 20 micron carbon fiber to enhance the tensile strength, but no data are given in respect to beneficially affecting composites. Of interest in this connection also are the ion plating with sputtering, plasma assisted, techniques described in Sumitomo Electric Ind. Japanese Patent Publication 8070-769 (1983) (C.A. 99:14622W), Japanese Patent Publication 8060063 (1983) (C.A. 99:144596), and Mitsubishi Electric Corp., Japanese Patent Publication 81,140,021 (1981) (C.A. 96:71290n), silane and methane deposit silicon/carbon in an inductive plasma. Sung, Dagli and Ying, describe surface modification of graphite substrates, both blocks and fibers, via plasma treatment in 37th Annual Conference, Reinforced Plastics/Composites Institute, The Society of the Plastics Industry, Inc., January 11-15, 1982, Session 23-B, Page 1-6. The technique employed was to use an inductively coupled plasma, in which the substrate is not excited. It is also disclosed that gas phase grafting can be achieved. Composites made from fibers modified by this technique had lower flexural strength, but better (but "not phenomenal") interlaminar shear strength than those made from untreated fibers. Also of interest is Toray Industries, Inc., Japanese Patent Publication 72,24,979 (1972) (C.A. 78:31295q) which discloses acrylic

vapor inductive plasma treatment of carbon fibers. Such techniques also do not give good uniform coatings if yarns or tows of fibers are to be treated because of rather poor penetration into the innermost fibers. Goan describes methods using an inductively coupled plasma (U.S. 3,776,829, ammonia, and U.S. 3,634,220, oxygen) to produce functionalized carbon fibers which beneficially enhance flexural strength, modulus and shear strength parallel to the line of fibers in epoxy resin composites. No beneficial effect on interlaminar shear strength is disclosed.

Unfortunately, the results which have been attained to date can be deemed to be generally inadequate, otherwise deficient, and/or are not readily reproducible. It is believed that a primary shortcoming is lack of uniform film deposition or incomplete fiber penetration. In addition, especially with ion plating methods, there are produced rough surface coatings which do not impart good handleability to substrates comprising yarns or tows. The coatings produced without fiber bias when ion plated in bundles of 2-3, are also rough and brittle, and the fibers fuse together. A need therefore exists for improving the physical properties of the composites to align these properties more closely to the theoretical.

## SUMMARY OF THE INVENTION

Accordingly, a primary object of this invention is to provide an improved surface treatment for reinforcing means intended for ultimate use in otherwise conventional composite assemblies.

Another object of this invention is to provide an apparatus for conducting such surface treatment.

Another object of this invention is to provide an improved composite assembly, the physical properties of which are enhanced or improved with respect to the prior art.

Still another object of the invention is to provide a substrate having enhanced surface characteristics such that it is eminently suitable for the fabrication of composites therefrom by reason of its great compatibility with great adhesiveness to various matrix components therefor.

In attaining these objects, one feature of this invention resides in subjecting a substrate, e.g., an electrically conductive substrate, such as carbon, silicon, silicon carbide, and the like, for example, in the form of fibers, filaments, fibrils, films, ribbons, sheets, plates, blocks, and the like to capacitively coupled plasma enhanced chemical vapor deposition while the substrate is in a radio frequency excited state. This differs from the prior art in that the plasma is capacitatively coupled and the substrate itself is radio frequency biased. This leads to more efficient and more uniform surface coating, even on the innermost fibers of a yarn or tow comprising bundles, e.g., of from 3,000 to 12,000 fibers. In addition, in preferred features, the radio frequency power can be varied to produce a wide range of predetermined modulus to match the properties to the matrix employed. Another feature of the invention

resides in post-treatment steps, including grafting with another monomer. Still another feature of this invention resides in the fabrication of various composite assemblies utilizing the thus treated substrates as the reinforcing means therefor and which composites exhibit enhanced and improved physical and/or mechanical properties such as tensile and/or bending strength, etc.

Other objects, features and advantages of the invention will be apparent to those skilled in the art from the detailed description of the invention which follows.

## BRIEF DESCRIPTION OF THE DRAWINGS

The invention may be more readily understood by reference to the accompanying drawings in which:

FIGURE 1 is a transverse cross sectional view of a film-coated fiber of this invention.

FIGURE 1a is a longitudinal cross sectional view of a film-coated fiber according to this invention.

FIGURE 2 is a view showing an apparatus for carrying out a process of the present invention.

FIGURES 2a, 2b and 2c are views of electrode configurations suitable for use in the apparatus shown in FIGURE 2 for carrying out the process of the present invention.

FIGURE 3 is a schematic view of an apparatus for continuously carrying out the plasma assisted chemical vapor deposition process of the present invention.

FIGURE 4 is a partial sectional view of a film-coated fiber-reinforced matrix composite of the present invention.

## DETAILED DESCRIPTION OF THE INVENTION

Plasma enhanced chemical vapor deposition is a very well known technique, as illustrated by some of the references mentioned above, being based on the equally well known phenomenon of plasma polymerization of monomeric gases which generate highly cross-linked, thin films (ca 1000 Angstroms in thickness) on the surface and, depending on the chemical nature of the substrates, coatings may also be grafted to the substrate. For plasma treatment, a radio frequency generator can be coupled to an impedence matching box and the output fed to a reactor. Typically, a power input of 10 to 100 watts will be used, preferably at a pressure not substantially in excess of about 5000 microns of mercury, most preferably in the range of 20 to 500 microns. The frequency of the power generator can vary widely, but it is usually in the range of from about 0.5 kHz to about 2500 MHz. Standard commercial units, which generate 13.6 MHz are convenient. The process can be carried out batchwise or continuously.

In the present invention, it is critical to the process to feed energy to the substrate to insure radio frequency excitation. In distinction with most processes of the prior art, in the present invention, the plasma is capacitatively coupled. Such features of this invention provide uniform and even film coating, even at the innermost fibers if multifilament fibers and tows are to be coated. While not critical, it is also very much preferred to operate at pressures substantially below atmospheric pressure and, especially preferably, below about 5000 microns of mercury. As mentioned, even more preferable is to operate in the range of 10 to 500 microns of mercury, and optimum results are achieved in the range of 10 to 100 microns of mercury.

According to the invention, and referring to FIGURE 2, the basic plasma coating apparatus consists of radio frequency (RF) generator 2 (13.56 MHz, Materials Research Corp.), impedence matching network 4, and gas impervious container 6 (a bell jar). Impedence matching network 4 permits optimum RF power transfer to the plasma. Mass flow monitor 8 (Matheson) measures gas flow into reactor 6. Monomer liquid is held in container 10. Inert gas, e.g., argon is held in tank 12. Dry nitrogen is stored in tank 14. Vacuum pump 16 is connected to the apparatus through cold trap 18, which is cooled, for example, with liquid nitrogen. Any of a number of electrode configurations can be used, for example, those shown in FIGURES 2a, 2b and 2c, respectively, wherein the substrate 20 is an electrode and is RF biased. The other electrode 22 is grounded. In all cases a configuration must be selected so as to provide uniform, non-directionally biased film deposition. Illustratively, if the electrode comprises the substrate and is a 10 inch length or 6,000 or 12,000 carbon fiber tow (e.g., CELION 6k and 12k, Celanese Corp.), and the RF power input is in the range of 10-100 watts at a pressure of 30 to 400 microns of mercury, uniform coatings in the range of 50 to 10,000 Angstroms, preferably 200 to 5,000 Angstroms, are readily produced with the innnermost fibers also being coated.

Feed and take up apparatus are readily constructed so that continuous tows can also be conveyed through the plasma and coated in accordance with the foregoing principles, and continuous methods are preferred features of the invention. A suitable apparatus is shown in FIGURE 3. Here, container 24 for the reaction zone comprises a quartz reaction tube. RF Generator and impedence matching network 26, are as described in FIGURE 2. The yarns or tows of graphite fiber 28 are

excited by passing over conductive rollers 30a and 30b before going through vacuum introduction bushing 32 into container tube 24. The other electrode comprises RF grounded screen 34. Gas is fed to reactor 24 through ports 36a and 36b, and means to pull a vacuum on the system comprises port 38 connected to a vacuum pump (not shown). To maintain gas tightness, the coated tow is removed through exit tube 38, which also is connected to vacuum. Support plates 40a and 40b hold the apparatus together and provide a grounding means for grounded screen electrode 34. Feed roll 42 and take up roll 44 are used to supply fiber and collect coated fiber. Optionally, as shown by D.C. unit 3 in FIG. 2 means for rendering the substrate D.C. conductive, comprising a battery, etc., can be interposed. This renders conductive substrate 20 capable of attracting charged ions and provides enhanced film properties in some instances.

As will be illustrated by the examples, the materials fed to the respective reactors, either elements, compounds, or mixtures thereof, will produce films by chemical vapor deposition, enhanced by plasma, of almost any type desired. The procedure in one aspect can coat elements, of at least one metal, semi-metal or non-metal, e.g., antimony, tungsten, titanium, silicon and alpha-carbon on the substrates. In another aspect, it will be shown that inorganic materials can be uniformly coated, such as $Si_xC_{1-x}$, $Al_2O_3$, CaO, $AlPO_4$, etc., as well as silicon/nitrogen, silicon/carbon, silicon/carbon/oxygen, silicon/carbon/oxygen/nitrogen and similar coatings. Such refractory coating will enhance molten metal wetting and impregnation of fiber bundles. For example, $AlPO_4$ on carbon will enhance wetting by aluminum; U.S. 4,008,299. Such coatings are also useful in the fabrication of ceramic composites because they impart oxidation resistance and control the bonding to the ceramic

matrix. These coatings are expected to provide abrasion resistance also, extending their use to commercial weaving or braiding equipment. In still another aspect, the substrates uniformly coated with a film of amorphous carbon having a high population of active sites, before removal from the plasma apparatus and while still under moderate vacuum, are exposed to a gas of a monomer or polymer that will react with the reactive site, gas phase grafting the monomer or polymer molecule to the amorphous carbon surface, and thereby functionalize an organic film. Such monomer or polymer is selected to give maximum compatibility for bonding to a matrix material. For example amorphous carbon coatings prepared in a styrene plasma can be selectively functionalized with nitrogen containing groups such as amides by briefly exposing the coating to an ammonia plasma before exposure to the ambient atmosphere. Amorphous carbon coatings can also be functionalized with oxygen containing groups by exposing the amorphous carbon coatings to ambient air. Carbon coatings put down in acrylic acid vapor result in free radical polymerization of acrylic acid on the fiber surface, and this can be verified by x-ray photo electron spectroscopy.

Referring to FIGS. 1 and 1a continuous bundles of fibers for use in the core 50 according to the present invention are available from a number of sources commercially. For example, suitable carbon fiber yarns are available from Hercules Company, Hitco, Great Lakes Carbon Company, AVCO Company and similar sources in the United States, and overseas. All are made, in general, by procedures described in U.S. 3,677,705. The fibers can be long and continuous or they can be short, e.g., 1 to 15 cm. in length.

The core can also include a metal, preferably as a surface layer, and especially preferably as an

 

electroplated metal layer comprising nickel, copper, lead, gold, silver, mixtures of the foregoing and the like. These preferably are made by procedures disclosed in assignee's European Patent Application No. 83101195.2 (September 21, 1983).

Film 52 will be of any metal, semi-metal or non-metal, element or compound, or mixture thereof which has been deposited on the core by plasma enhanced chemical vapor deposition. Two layers, or even more, of such films can be applied and the films can be the same or different, as will be shown in the working examples.

In other embodiments (not shown), the core can comprise a plate-like substrate and an adhesive or coating can be applied over the film, and the adhesive continuous phase serves as the matrix therefor. In order to demonstrate the beneficial influence of the respective films on such substrates, the plates can be coated with thin layers of adhesives comprising, for example a thin layer of bisphenol A diepoxide and diethylenetriamine. Curing the resin at 16 hours and then for 80°C for 2 hours provides significant increases in bonding strength, due to the presence of the surface film of this invention.

The film coated fibers of this invention can be assembled by conventional means into composites represented in FIG. 4 in which matrix 54 is a plastic, e.g., epoxy resin, a polyimide resin or a ceramic, e.g., glass, the matrix being reinforced by virtue of the presence of film-coated fibrous cores 50.

To make polymeric matrix, fiber-reinforced composites, any method known in the art, such as the methods described in assignee's European Patent Application No. 83101196.0 (October 5, 1983), can be used. The polymeric material can be film coated, melt blended, solvent blended, or the like, onto the film coated

reinforcement in the form of fibers, yarns or tows, woven, braided or knitted fabrics, non-woven sheets, chopped fibers and the like. Suitable resins are polyesters, polyethers, polycarbonates, epoxies, phenolics, epoxynovolacs, epoxy-polyurethanes, ureatype resins, phenolformaldehyde resins, melamine resins, melamine thiourea resins, urea-aldehyde resins, alkyd resins, polysulfide resins, vinyl organic prepolymers, multifunctional vinyl ethers, cyclic ethers, cyclic esters, polycarbonate-coesters, polycarbonate-cosilicones, polyetheresters, polyimides, polyamides, polyesterimides, polyamideimides, polyetherimides, and polyvinyl chlorides, mixtures of any of the foregoing, and the like. The polymeric material may be present alone or in combination with copolymers and polymeric blends may also be used. The polymeric material may, when combined with the coated reinforcement of this invention, be convertible by heat or light, alone or in combination with catalysts, accelerators, cross-linking agents, etc., to form components suitable for end uses, such as airfoils, protective clothing, sporting equipment, office machinery housings, television cabinets and the like. The amount of reinforcement used will be conventional, but preferably, the reinforcement will comprise at least about 40 percent by volume of the composite.

To make ceramic matrix, reinforced composites, any method known in the art, such as the methods described in Carbon and Graphite Fibers, Ed. Marshall Sittig, Noyes Data Corp., 1980, pp. 263-269, can be used. Film coated fibers, e.g., at least 40 percent by volume, can be formed into composites with ceramics, such as glass, cement and refractory compounds, such as niobium carbide or tantalum carbide. Thermal shock resistance and reduction in brittleness are two properties beneficially affected by reinforcing ceramics in this way.

## DESCRIPTION OF THE PREFERRED EMBODIMENTS

The following non-limiting examples illustrate the present invention.

The basic plasma coating apparatus is represented schematically in FIGURE 2. The components comprised a radio frequency (RF) generator (13.56 MHz, Materials Research Corp.), an impedence matching network and a container comprising a bell jar or a tubular reactor (FIG. 3). The impedence matching network permits optimum RF power transfer to the plasma. Gas flow into the reactor was measured by a Matheson mass flow monitor. The electrode configurations employed are shown in FIGS. 2a-c, with the actual configuration specified in the respective example. The RF power input to the reactor typically was in the range of 10 to 100 watts at pressures of 30 to 400 microns of mercury. Most examples were performed on 10 inch lengths of Celion 6k, 6000 carbon fiber tows. However, for continuous processing, a feed and take up apparatus was constructed to continuously convey the tow through the plasma with a total capacity of 10 meters.

The surface effects of the plasma assisted chemical vapor deposition (CVD) were characterized using x-ray photoelectron spectroscopy (XPS) and scanning electron microscopy on both treated and untreated fiber samples.

### EXAMPLE 1

Antimony (Sb) Deposition from $SbCl_5$ Vapor. - The apparatus of FIG. 2 was used with an electrode configuration shown. The RF power was 20 watts, the total pressure was 40 mTorr (40 microns) of $SbCl_5$ vapor. The reactor background pressure was 10 mTorr. After 15 minutes of exposure, a metallic looking coating ca 1000 Angstroms thick of antimony was obtained uniformly on each fiber in the bundle. There was no non-uniform

directionally biased film deposition.

EXAMPLE 2

Titanium (Ti) Deposition from $TiCl_4$ Vapor and Hydrogen. - The apparatus of FIG. 2 was used with an electrode configuration shown. The RF power was 10 watts, and the total pressure was 100 mTorr. The reactor background pressure was 10 mTorr. After 15 minutes of exposure, fibers were obtained evenly coated with a thin film of titanium, *ca* 5000 Angstroms thick.

EXAMPLE 3

Tungsten (W) Deposition from $WF_6$ and Hydrogen. The apparatus of FIG. 2 was used with an electrode configuration shown. The RF power was 20 watts, and the total pressure was 100 mTorr. The reactor background pressure was 10 mTorr. The reactor pressure was increased to 20 mTorr with $WF_6$. The reactor was then pressurized from 20 mTorr to 100 mTorr with $H_2$. After 10 minutes, a coating of tungsten was deposited, *ca* 5000 Angstroms thick.

EXAMPLE 4

Silicon (Si) Deposition from $SiH_4$ and Argon. - The apparatus of FIG. 2 was used with an electrode configuration shown. The RF power was 25 watts. The total pressure was 40 mTorr ($SiH_4$ + Ar). The system background pressure was 10 mTorr. The reactor pressure was raised to 30 mTorr with Ar then increased to 40 mTorr with $SiH_4$. After 5 minutes, an even coating of Si about 1 micron (10,000 Angstroms) thick was deposited on the fibers.

0154814

EXAMPLE 5

Alpha-Carbon (C) Deposited from Styrene Vapor. The apparatus of FIG. 2 was used with an electrode configuration shown. The RF power was 50 watts. The total pressure was 60 mTorr. The background pressure was 10 mTorr. The reactor pressure was increased to 60 mTorr with styrene vapor. After 3 minutes, a thin, uniform film of alpha-carbon ca 1000 Angstroms thick was deposited on the fibers.

EXAMPLE 6

Carbon-Silicon ($Si_xC_{i-x}$) Deposition from $SiH_4$, $CH_4$ and Argon. - The apparatus of FIG. 2 was used with an electrode configuration shown. The RF power was 20 watts, and the total pressure was about 56-58 mTorr. The $CH_4$ flow rate was 1.7 standard cubic centimeters per minute (SCCM). The $SiH_4$ flow rate was 1.7 SCCM. The Ar flow rate was 21.2 SCCM. After 1 hour, a thin carbon-silicon film ca 1500 Angstroms was evenly coated on the fibers.

EXAMPLE 7

Carbon-Silicon ($Si_xC_{i-x}$) Deposition from $SiH_4$ and $C_2H_2$. - The apparatus of FIG. 2 was used with an electrode configuration shown. The RF power was 40 watts, and the total pressure was 26 mTorr. The $SiH_4$ flow rate was 1.8 SCCM. The $C_2H_2$ flow rate was 1.75 SCCM. After 1 hour, a carbon-silicon film about 1 micron thick was evenly coated on the fibers.

EXAMPLE 8

Silicon-Nitrogen ($Si_xN_y$) Deposition from $SiCl_4$, $NH_3$ and $N_2$. - The apparatus of FIG. 2 was used with an electrode configuration shown. The RF power was 20 watts, and the total pressure was about 40 mTorr.

The $NH_3$ flow rate was 1.0 SCCM. The $N_2$ flow rate was 1.5 SCCM. The $SiCl_4$ flow rate was 0.7 SCCM. After 45 minutes, carbon fibers thinly and uniformly coated with a film comprising silicon-nitrogen ca 5000 Angstroms thick were obtained.

EXAMPLE 9

Silicon-Carbon-Oxygen-Nitrogen (SiCON)

Deposition from $SiH_4$, $CH_4$, Air and Argon. - The apparatus shown in FIG. 2 was used with an electrode configuration shown. The RF power was 20 watts. The total pressure was 60 mTorr. Air comprised 20 mTorr. The system was brought to 60 mTorr by flowing in $SiH_4$, $CH_4$ and Argon gas at the following flow rates: $SiH_4$, 1.7 SCCM; $CH_4$, 1.7 SCCM; and Argon 21.2 SCCM. After 1 hour a thin uniform film ca 6000-7000 Angstroms thick was deposited, having the following elemental composition: C, 22.4 Atomic %; O, 44.5 Atomic %; N, 7.4 Atomic %; and Si, 25.8 Atomic %.

EXAMPLES 10-12

The general procedure of Example 6 was repeated, substituting for the styrene plasma, plasmas of butane and acrylic acid vapors. In all cases amorphous carbon (alpha-carbon) films were deposited.

EXAMPLES 13-14

By the procedure of Example 6, substituting an acrylic acid plasma for a styrene plasma, and subsequently exposing the amorphous alpha carbon film coated fibers to laboratory air, there is obtained significantly increased amounts of oxygen on the surface (by XPS), and a changed distribution of functionalities (more $-\underset{|}{\underset{O}{C}} = O$

groups than on the untreated fiber surface. XPS analysis of the film gave the following composition: $O_{1s}$, 8.81 Atomic %; $O_{1s}$, 2.26 Atomic %; $C_{1s}$, 65.58 Atomic %; $C_{1s}$, 16.0 Atomic %; and $C_{1s}$, 7.36 Atomic %.

If the procedure is repeated, except that the film is first exposed to acrylic acid monomer vapor immediately after alpha-carbon film deposition, and then exposed (after evacuation) to air, there is obtained a more selectively functionalized surface: a significant increase in the amount of C-O groups and a decrease in the amount of C = O groups.

XPS analysis of the film gave the following results: $O_{1s}$, 11.16 Atomic %; $O_{1s}$, 3.15 Atomic %; $C_{1s}$, 58.0 Atomic %; $C_{1s}$, 21.17 Atomic %; and $C_{1s}$, 6.52 Atomic %.

EXAMPLES 15-17

The apparatus of FIG. 2 was used with the electrode configuration shown. The RF power was 25 watts. The vacuum system was initially filled to 20 microns pressure with Argon and then filled to 40 microns with styrene vapor. After 10 minutes, the alpha-carbon film coated fibers were exposed to air. The amount of $O_{1s}$ was 5.3 Atomic %, and $C_{1s}$ was 94.7 Atomic %. The process was repeated but, instead of air, the alpha-carbon film was exposed immediately to ammonia gas at 1000 microns for 15 minutes. The film was analyzed by XPS analysis and showed a trace amount of nitrogen: $O_{1s}$, 6.25 Atomic %; $C_{1s}$, 92.4 Atomic %; and $N_{1s}$, 1.32 Atomic %. When the procedure was repeated, but using a post treatment in an ammonia plasma (20 watts RF power at 2 min. at an ammonia pressure of 50 microns), the N/O ratio of ~ 1 in the analyzed film indicated that the nitrogen is present in the form of $NH_2$ groups. The

analysis was $O_{1s}$ 8.11 Atomic %; $C_{1s}$, 83.4 Atomic %; and $N_{1s}$, 8.44 Atomic %. In all cases the coatings were about 1000 Angstroms thick.

EXAMPLE 17

Silicon (Si) Deposition from $SiH_4$ on Nickel Coated Carbon Fiber Substrate. - The apparatus of FIG. 2 was used with an electrode configuration shown. The substrate comprised a 6000 carbon fiber tow coated with 50 wt.% nickel by the electroplating process described in assignee's above-mentioned European Patent Application No. 83101195.2 Example 1. The RF power was 30 watts. The total pressure was 33 microns of mercury. The flow rate of $SiH_4$ was 3.5 SCCM. After 10 minutes, an even coating of Si about 10,000 Angstroms thick was deposited on the nickel coated carbon fiber.

EXAMPLE 18

A pyrolytic graphite plate was placed in the apparatus of FIG. 2 and biased with RF power of 40 watts. The total pressure was 80 mTorr. The reactor was evacuated to 4 mTorr, then backfilled to 42 mTorr with $H_2$, and further filled to 80mTorr with $Al(CH_3)_3$. The deposition time was 30 minutes. A uniform film was deposited on the plate and comprised $Al_xO_yH_y$, wherein $X \leq 2$, and $Y \leq 3$. After heat-treatment to $\sim$ 1000°C, the film formed stoichiometic $Al_2O_3$.

EXAMPLE 19

An array is made of aligned graphite yarns coated with a selectively functionalized alpha-carbon film by the procedure of Example 17. These are impregnated with a heat curable composition comprising an epoxy resin and a polyamine curing agent. The arrays are assembled into a three-dimensional shape and the

epoxy resin is heat cured to provide a composite in which the resin is the matrix and the film coated graphite yarns are the reinforcing phase (about 40-50% by volume). The composite exhibits improved short beam shear strength in comparison with one made with graphite yarns which are not coated in accordance with the present invention.

EXAMPLE 20

A film coated fiber tow comprising carbon and coated with a carbon-silicon film by the procedure of Example 7 is converted into a ceramic matrix composite by fusing powdered glass to the reinforcement (about 40% by volume of the reinforcement). The composite exhibits better stability after thermal cycling in an oxidative atmosphere than does one reinforced with fibers not coated with film in accordance with the present invention.

The composite articles of the examples containing the plasma coated fibers will find use in applications where light weight, stiff components are needed, such as support beams in space structures, lightweight bridging, internal engine components on gas turbines and internal combustion equipment for aircraft, space vehicles, and the like.

The foregoing patents and publications are incorporated herein by reference. Many variations of the present invention will suggest themselves to those skilled in this art in light of the above, detailed description. For example, composites comprising epoxy or polyimide polymeric matrixes reinforced with fibers coated by the procedures of Examples 1-15 and 17 can be prepared. And composites comprising other ceramics, and cement, can be prepared, reinforced with fibers coated by the procedures of Examples 1-6 and 8-17. In addition, the radio frequency power can be varied to produce a film with a predetermined modulus. Higher power produces

a higher modulus. Wattages in the range of 10 to 100 produce film moduli in the range of 300,000 to 30,000,000 pounds per square inch. Calibration charts can be easily prepared to convert power to ultimate modulus. All such variations are within the full intended scope of the invention as defined in the appended claims.

CLAIMS:

29,547

1. A coated substrate comprising a radio frequency conductive core and at least one thin, uniform, firmly adherent, organic film comprising carbon and at least one other non-metal deposited on said core by plasma enhanced chemical vapor deposition while said core is radio frequency excited.

2. A coated substrate as defined in Claim 1 wherein said organic film has been deposited on said core at an applied radio frequency power selected to produce a film having a predetermined modulus.

3. A coated substrate as defined in Claim 1 wherein said organic film is functionalized.

4. A coated substrate as defined in Claim 3 wherein said functionalized organic film has been deposited on said core at an applied radio frequency power selected to produce a film having a predetermined modulus.

5. A coated substrate as defined in Claim 2 wherein the applied radio frequency power is within the range of from about 10 to about 1000 watts, and the modulus of the film is in the range of from about 300,000 to about 30,000,000 pounds per square inch.

6. A coated substrate as defined in Claim 4 wherein the applied radio frequency power is within the range of from about 10 to about 1000 watts, and the modulus of the film is in the range of from about 300,000 to about 30,000,000 pounds per square inch.

7. A coated substrate as defined in Claim 1 wherein the film is deposited on said core at a vapor pressure not substantially in excess of about 5,000 microns of mercury.

8. A coated substrate as defined in Claim 7 wherein the film is deposited on said core at a vapor pressure in the range of from about 20 to about 500 microns of mercury.

9. A coated substrate as defined in Claim 1 wherein the thickness of the film is in the range of from about 50 to about 10,000 Angstroms.

10. A coated substrate as defined in Claim 9 wherein the thickness of the film is in the range of from about 200 to about 5,000 Angstroms.

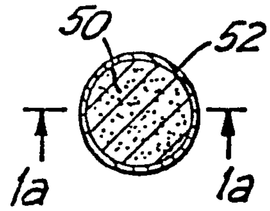


FIG.1

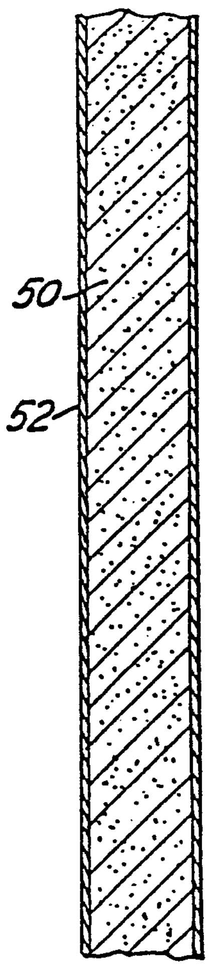


FIG.1a

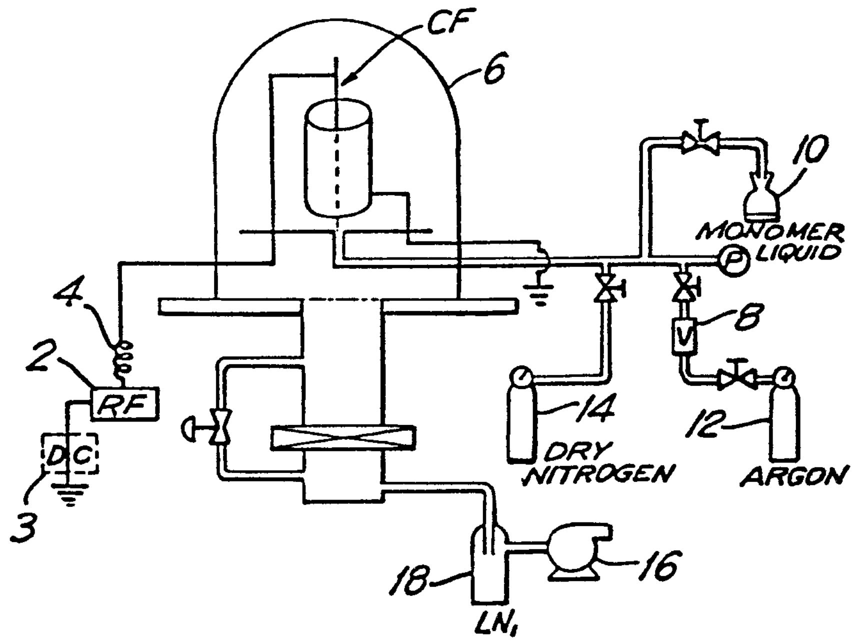


FIG.2

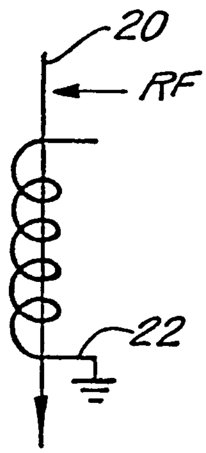


FIG.2a

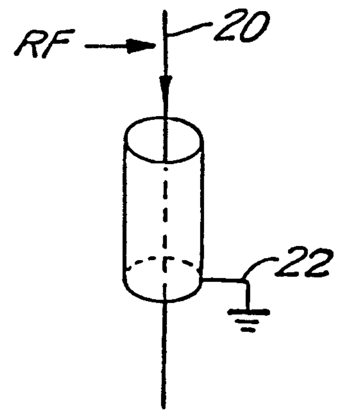


FIG.2b

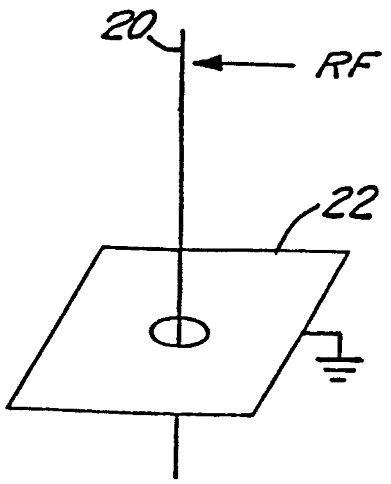


FIG.2c

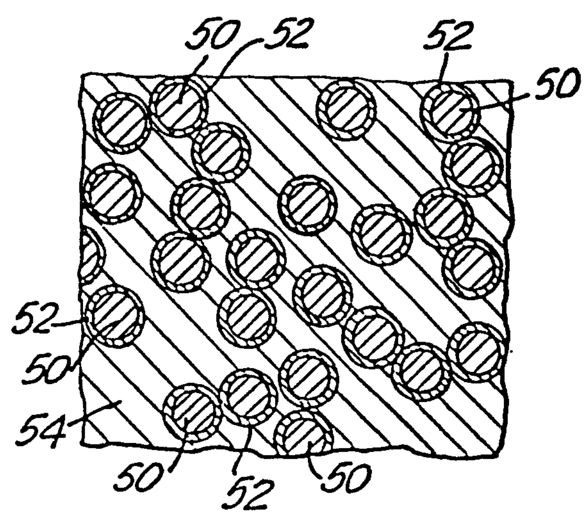


FIG.4

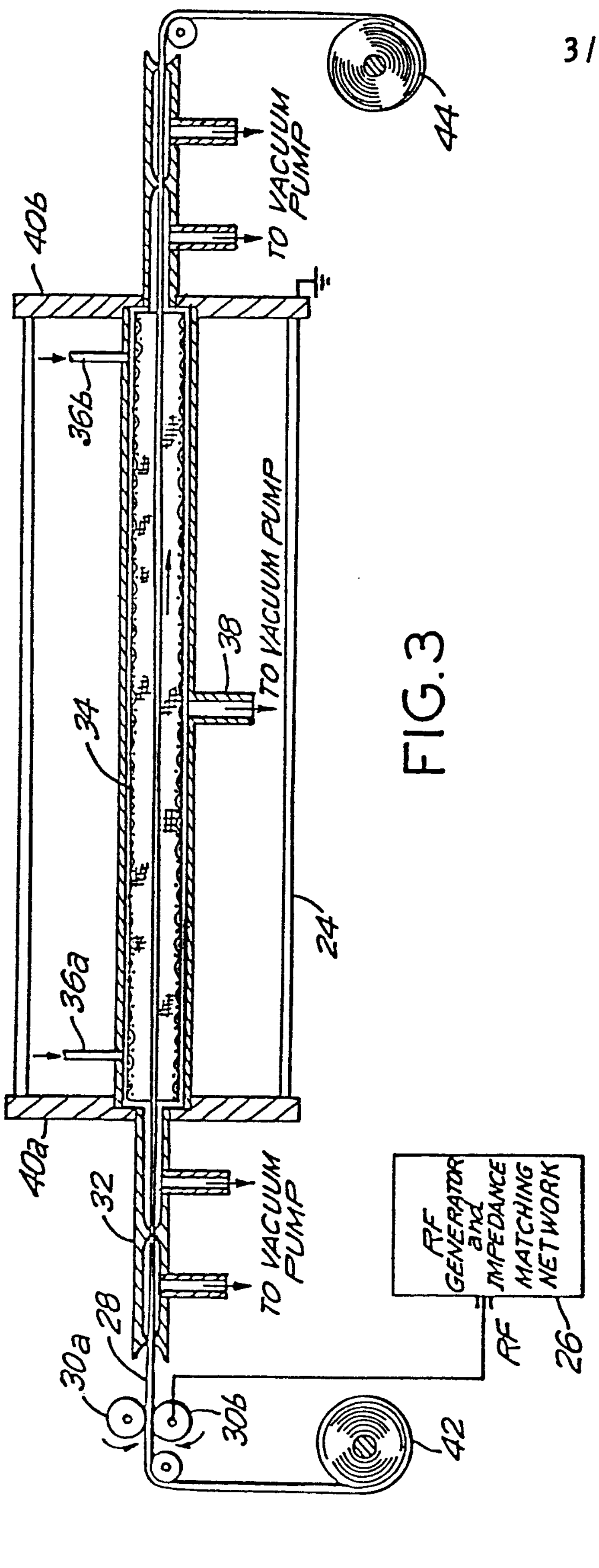

40b
44
TO VACUUM PUMP
36b
TO VACUUM PUMP
38
34
36a
24
40a
32
TO VACUUM PUMP
28
30a
30b
42
RF GENERATOR and IMPEDANCE MATCHING NETWORK
RF
26


FIG.3